**Europäisches Patentamt**

(19) **European Patent Office**

**Office européen des brevets**

(11) Veröffentlichungsnummer: **0 034 207**

**A1**

(12) # EUROPÄISCHE PATENTANMELDUNG

(21) Anmeldenummer: **80107488.1**

(22) Anmeldetag: **28.11.80**

(51) Int. Cl.³: **H 01 L 23/10**
**H 01 L 23/30, H 01 L 21/56**

(30) Priorität: **13.02.80 DE 8003735 U**

(43) Veröffentlichungstag der Anmeldung:
**26.08.81 Patentblatt 81/34**

(84) Benannte Vertragsstaaten:
**AT CH DE FR GB IT LI NL SE**

(71) Anmelder: **ROBERT BOSCH GMBH**
**Postfach 50**
**D-7000 Stuttgart 1(DE)**

(72) Erfinder: **Heyke, Klaus, Dr. Dipl.-Ing.**
**Bodächerstrasse 23**
**D-7410 Reutlingen(DE)**

(72) Erfinder: **Vohr, Armin**
**Lammstrasse 33**
**D-7410 Reutlingen 24(DE)**

(72) Erfinder: **Breuer, Peter**
**Holunderweg 14**
**D-7300 Esslingen(DE)**

(72) Erfinder: **Gebhardt, Heinz**
**Hohenzollernstrasse 3**
**D-7401 Nehren(DE)**

(72) Erfinder: **Michel, Hartmut, Dipl.-Ing.**
**Aaranstrasse 56**
**D-7410 Reutlingen(DE)**

(72) Erfinder: **Ressler, Siegfried**
**Kusterdingerstrasse 16**
**D-7415 Wannweil(DE)**

(72) Erfinder: **Weidner, Michael, Dipl.-Phys.**
**Bismarckstrasse 31**
**D-7410 Reutlingen(DE)**

(72) Erfinder: **Zipperer, Wilfried**
**Büchnerstrasse 2**
**D-7410 Reutlingen(DE)**

(54) **Halbleiterbauelement.**

(57) Es wird ein rotationssymmetrisch ausgebildetes Halbleiterbauelement vorgeschlagen. Das Halbleiterbauelement besitzt zwei Anschlußleiter (1,2). Der erste Anschlußleiter (1) bildet einen Metallsockel, der aus einem tellerförmigen Unterteil (1a) und aus einer einstückig mit dem Unterteil (1a) ausgebildeten mittleren Erhöhung (1b) besteht. Zwischen der mittleren Erhöhung (1b) des ersten Anschlußleiters (1) und dem zweiten Anschlußleiter (2) ist ein scheibenförmiger Halbleiterkörper (6) festgelötet. Eine Kunstharzmasse (10) überdeckt die mittlere Erhöhung (1b) des ersten Anschlußleiters (1), den äußeren Rand des scheibenförmigen Halbleiterkörpers (6) und Teile des zweiten Anschlußleiters (2). Die Kunstharzmasse (10) füllt ein zylinderförmiges Mantelteil (12) aus, das auf das tellerförmige Unterteil (1a) des ersten Anschluß-leiters (1) aufgesetzt ist. Das zylinderförmige Mantelteil (12) umgreift einen treppenförmigen Absatz (1c) des tellerförmigen Unterteils (1a).

./...

Croydon Printing Company Ltd.

R. 6054

31.1.1980 Fb/Sm

Robert Bosch GmbH, 7000 Stuttgart 1

Halbleiterbauelement

Stand der Technik

Die Erfindung geht aus von einem Halbleiterbauelement
nach der Gattung des Hauptanspruchs. Aus der DE-PS
15 89 555 ist bereits ein Halbleiterbauelement dieser
Art bekannt, bei dem die Kunstharzmasse den äußersten
Mantel bildet und die Form eines Kegelstumpfes hat.
Dieses Halbleiterbauelement hat den Nachteil, daß der
Kunstharzmantel durch Spritzpressen hergestellt werden
muß.

Vorteile der Erfindung

Das erfindungsgemäße Halbleiterbauelement mit den kennzeichnenden Merkmalen des Hauptanspruchs hat demgegenüber den Vorteil, daß die Kunstharzmasse durch Ausgießen
des vorher aufgebrachten zylinderförmigen Mantelteils
hergestellt werden kann.

Zeichnung

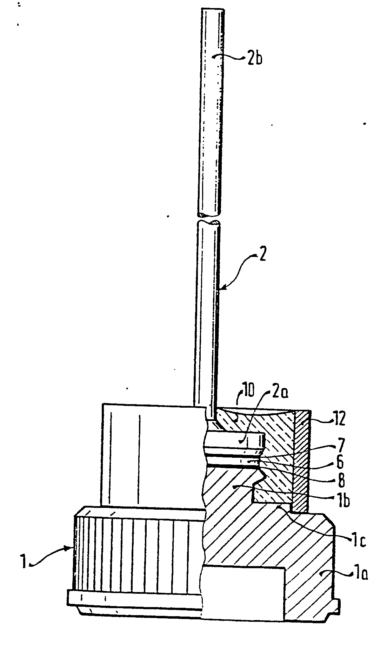

Ein Ausführungsbeispiel des erfindungsgemäßen Halbleiterbauelements ist in der Zeichnung dargestellt und in der
nachfolgenden Beschreibung näher erläutert. Die einzige Figur zeigt das Bauelement, teilweise im Schnitt, teilweise im Aufriß.

## Beschreibung des Ausführungsbeispiels

Der in der Zeichnung dargestellte Leistungsgleichrichter besitzt einen als Metallsockel ausgebildeten Anschlußleiter 1 und einen als Kopfdraht ausgebildeten Anschlußleiter 2, dessen Kopfteil mit 2a und dessen drahtförmiger Teil mit 2b bezeichnet ist. Die Anschlußleiter 1, 2 bestehen vorzugsweise aus Kupfer und können mit einer dünnen Nickelschicht überzogen sein. Der als Metallsockel ausgebildete Anschlußleiter 1 besteht aus einem tellerförmigen Unterteil 1a und aus einer einstückig mit dem tellerförmigen Unterteil ausgebildeten mittleren Erhöhung 1b. Die mittlere Erhöhung 1b hat etwa denselben Durchmesser wie das nach unten gerichtete Kopfteil des Anschlußleiters 2. Zwischen der mittleren Erhöhung 1b und dem Kopfteil 2a ist eine Halbleiterscheibe 6 mittels zweier Lotschichten 7, 8 festgelötet.

Auf das tellerförmige Unterteil 1a des ersten Anschlußleiters 1 ist ein zylinderförmiges Mantelteil 12 aufgesetzt, das in axialer Richtung des Bauelements sich bis über das Kopfteil 2a des Anschlußleiters 2 hinaus erstreckt. In den Zwischenraum zwischen den Teilen 2b, 2a, 7, 6, 8, 1b des Halbleiterbauelements einerseits und dem Mantelteil 12 andererseits ist eine Kunstharzmasse 10 eingegossen, die zur Abdichtung des Bauelements gegen atmosphärische Einflüsse dient. Das zylinderförmige Mantelteil 12 umgreift einen treppenförmigen Absatz 1c des tellerförmigen Unterteils 1a.

R. **6054**
31.1.1980 Fb/Sm

Robert Bosch GmbH, 7000 Stuttgart 1

Ansprüche

1. Rotationssymmetrisch ausgebildetes Halbleiterbauelement mit zwei Anschlußleitern (1, 2), bei dem der erste Anschlußleiter (1) einen Metallsockel bildet, wobei der Metallsockel aus einem tellerförmigen Unterteil (1a) und aus einer einstückig mit diesem Unterteil ausgebildeten mittleren Erhöhung (1b) besteht, bei dem ein scheibenförmiger Halbleiterkörper (6) zwischen der mittleren Erhöhung (1b) des ersten Anschlußleiters (1) und dem zweiten Anschlußleiter (2) festgelötet ist und bei dem eine Kunstharzmasse (10) die mittlere Erhöhung (1b) des ersten Anschlußleiters (1), den äußeren Rand des scheibenförmigen Halbleiterkörpers (6) und Teile des zweiten Anschlußleiters (2)überdeckt, dadurch gekennzeichnet, daß die Kunstharzmasse (10) ein zylinderförmiges Mantelteil (12) ausfüllt, das auf das tellerförmige Unterteil (1a) des ersten Anschlußleiters (1) aufgesetzt ist.

. . .

0034207

R. 6054
Fb/Sm

2. Halbleiterbauelement nach Anspruch 1, dadurch gekennzeichnet, daß das zylinderförmige Mantelteil (12) einen treppenförmigen Absatz (1c) des tellerförmigen Unterteils (1a) umgreift.

| | Europäisches Patentamt | EUROPÄISCHER RECHERCHENBERICHT | | Nummer der Anmeldung<br>EP 80 10 7488.1 |

## EINSCHLÄGIGE DOKUMENTE

| Kategorie | Kennzeichnung des Dokuments mit Angabe, soweit erforderlich, der maßgeblichen Teile | betrifft Anspruch |
|---|---|---|
| | DE - A - 2 042 333 (SIEMENS AG)<br>* Ansprüche 1, 3; Fig. 2 *<br>-- | 1 |
| | DE - A1 - 2 654 960 (TEXAS INSTRU-MENTS DEUTSCHLAND)<br>* Seite 7, erster Absatz; Fig. 1 *<br>-- | 1 |
| P | DE - A1 - 3 011 491 (S.E.V. ALTERNA-TEURS)<br>* Anspruch 3; Seite 13, Absatz 2 bis Seite 14, Absatz 1 ; Fig. 1 *<br>-- | 1 |
| A | DE - B2 - 1 589 555 (ROBERT BOSCH GMBH)<br>---- | |

**KLASSIFIKATION DER ANMELDUNG (Int. Cl.³)**

H 01 L 23/10
H 01 L 23/30
H 01 L 21/56

**RECHERCHIERTE SACHGEBIETE (Int. Cl.³)**

H 01 L 21/50
H 01 L 23/02
H 01 L 23/24
H 01 L 23/28

**KATEGORIE DER GENANNTEN DOKUMENTE**

X: von besonderer Bedeutung
A: technologischer Hintergrund
O: nichtschriftliche Offenbarung
P: Zwischenliteratur
T: der Erfindung zugrunde liegende Theorien oder Grundsätze
E: kollidierende Anmeldung
D: in der Anmeldung angeführtes Dokument
L: aus andern Gründen angeführtes Dokument
&: Mitglied der gleichen Patentfamilie, übereinstimmendes Dokument

X Der vorliegende Recherchenbericht wurde für alle Patentansprüche erstellt.

| Recherchenort | Abschlußdatum der Recherche | Prüfer |
|---|---|---|
| Berlin | 30-04-1981 | GIBBS |

EPA form 1503.1 06.78